# EUROPÄISCHE PATENTSCHRIFT

(11) **EP 0 387 721 B1**
(45) Veröffentlichungstag und Bekanntmachung des Hinweises auf die Patenterteilung: **24.01.1996**
(21) Anmeldenummer: 90104520.3
(22) Anmeldetag: 09.03.1990
(51) Int. Cl.: H01L 29/74

(54) **Thyristor mit verbessertem Abschaltverhalten**
Thyristor having a particular switching behaviour
Thyristor à comportement en commutation amélioré

(30) Priorität: 14.03.1989 DE 3908281
(43) Veröffentlichungstag der Anmeldung: 19.09.1990
(73) Patentinhaber: SIEMENS AKTIENGESELLSCHAFT, D-80333 München (DE)
(72) Erfinder: Oppermann, Klaus-Günter, Dipl.-Phys., D-8150 Holzkirchen (DE)

(56) Entgegenhaltungen:
- EP-A- 0 060 912
- EP-A- 0 190 934
- EP-A- 0 262 958
- US-A- 3 855 611
- US-A- 4 079 403
- PATENT ABSTRACTS OF JAPAN vol. 1, no. 49 (E-19) 13. Mai 1977 & JP-A-51 145 282

## Beschreibung

Die Erfindung bezieht sich auf einen abschaltbaren Thyristor nach den Oberbegriffen der Patentansprüche 1 und 2.

Ein Thyristor, der auch als GTO-Schalter bezeichnet wird, ist aus den Electronic Components and Applications, Vol. 3, No. 4, Aug. 1981, S. 232-237, bekannt. Beim Abschalten desselben ergibt sich ein zeitlicher Verlauf des Laststroms I, der in einem als Fallperiode bezeichneten Zeitabschnitt einen steilen Stromabfall und in einem sich unmittelbar anschließenden Zeitabschnitt (Tailperiode) einen sehr flachen Stromabfall aufweist. Letzterer entsteht dadurch, daß die während der Durchlaßphase im GTO-Schalter gespeicherten Überschußladungsträger während des Aufbaues einer Raumladungszone am mittleren pn-Übergang, der sich beim Abschalten vollzieht, nicht vollständig ausgeräumt werden können. Die verbleibenden Überschußladungsträger können nur rekombinieren oder durch das Feld der Raumladungszone beschleunigt und somit in Richtung auf die kathoden- bzw. anodenseitige Elektrode des Schalters abtransportiert werden. Dieser durch die Raumladungszone fließende Diffusionsstrom ruft jedoch hohe Abschaltverluste hervor.

Ferner ist aus der europäischen Patentanmeldung mit der Veröffentlichungsnummer 0 262 958 ein Thyristor nach den Oberbegriffen der Ansprüche 1 und 2 bekannt, bei dem durch eine in der n-Basis vorgesehene hochdotierte Teilschicht, die an einer Hauptfläche mit einer leitenden Belegung kontaktiert und mit entsprechenden Spannungsimpulsen beaufschlagt ist, diese Überschußladungsträger vergleichsweise schnell entfernt und damit die Abschaltverluste gesenkt werden.

Aus der europäischen Patentanmeldung mit der Veröffentlichungsnummer 0 190 934 ist weiter ein Herstellverfahren für einen Thyristor mit entsprechend kontaktierter, hochdotierter Teilschicht bekannt.

Der Erfindung liegt die Aufgabe zugrunde, einen Thyristor der eingangs genannten Art anzugeben, bei dem der Diffusionsstrom und damit die Tailperiode beim Abschalten weitgehend vermieden werden. Das wird erfindungsgemäß durch eine Ausbildung nach den kennzeichnenden Teilen der Patentansprüche 1 oder 2 erreicht.

Der mit der Erfindung erzielbare Vorteil liegt insbesondere darin, daß das Absaugen der im leitenden Zustand des Thyristors in der ersten Basisschicht angesammelten Überschußladungsträger hauptsächlich über eine hoch dotierte Teilschicht der ersten Basisschicht erfolgt, die seitlich am Halbleiterkörper mit einer leitenden Belegung kontaktiert ist, so daß die durch den Abtransport dieser Ladungsträger entstehende Verlustleistung niedriger ist als bei bekannten Thyristoren dieser Art, da die Ladungsträger auf kürzestem Weg abgeführt werden.

Die Erfindung wird nachfolgend anhand der Zeichnung näher erläutert. Dabei zeigt:
- Figur 1: ein Strom-Zeit-Diagramm zur Erläuterung des angestrebten technischen Effekts,
- Figur 2: ein erstes Ausführungsbeispiel der Erfindung,
- Figur 3: ein zweites Ausführungsbeispiel der Erfindung und
- Figur 4: das Dotierungsprofil eines Thyristors gemäß Figur 2 oder 3.

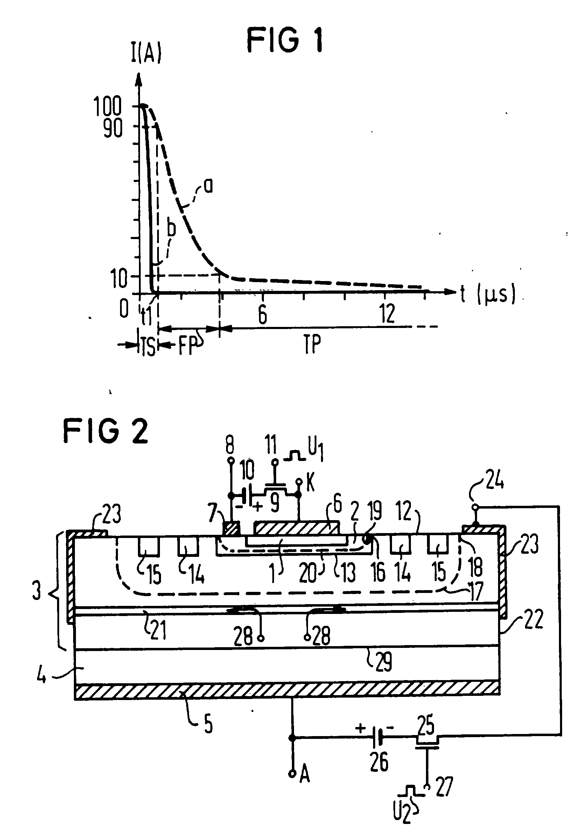

In Figur 1 bezeichnet a den zeitlichen Verlauf des Laststroms I beim Abschalten eines herkömmlichen GTO-Thyristors. Dabei ist über der in µs angegebenen Zeit t die jeweilige Stromstärke des Laststroms I in Ampere aufgetragen. Beträgt die Laststromstärke im Zeitpunkt des Anlegens eines Löschspannungsimpulses, das heißt für t = 0, zunächst 100 A und verringert sie sich bis zum Zeitpunkt t1 auf 90 % des ursprünglichen Wertes, das heißt auf 90 A, so wird der zugeordnete Zeitabschnitt TS als Speicherzeit bezeichnet. Hieran schließen sich der bereits erwähnte steile Stromabfall innerhalb der Fallperiode FP und der flache Stromabfall innerhalb der Tailperiode TP an. FP umfaßt hierbei den Zeitraum, in dem sich der Laststrom I von 90 % auf 10 % seines ursprünglichen Wertes verringert. Die Tailperiode TP reicht in Figur 1 über den rechten Rand des I/t-Diagramms hinaus und könnte zum Beispiel 20 µs betragen.

In Figur 2 ist ein abschaltbarer Thyristor dargestellt, bei dem die Tailperiode TP weitgehend entfällt. Er weist einen aus dotiertem Halbleitermaterial, zum Beispiel Silizium, bestehenden, scheibenförmigen Halbleiterkörper mit vier aufeinanderfolgenden Schichten abwechselnder Leitungstypen auf. Von diesen bezeichnet man die n⁺-dotierte Schicht 1 als den n-Emitter, die p⁺-dotierte Schicht 2 als die p-Basis, die n⁻-dotierte Schicht 3 als die n-Basis und die p⁺-dotierte Schicht 4 als den p-Emitter. Dieser ist mit einer anodenseitigen Elektrode 5 aus elektrisch leitendem Material, zum Beispiel Aluminium, versehen, die einen Anschluß A aufweist. Der n-Emitter wird von einer mit einem Anschluß K versehenen kathodenseitigen Elektrode 6 aus elektrisch leitendem Material, zum Beispiel Aluminium, kontaktiert. Eine mit einem Anschluß 8 versehene Gateelektrode 7 kontaktiert die p-Basis 2. Dem Anschluß 8 wird zum Zünden des Thyristors eine gegenüber K positive Zündspannung zugeführt. Zum Abschalten bzw. Löschen des Thyristors wird ein Schalter 9 geschlossen, über den eine Spannungsquelle 10 zwischen K und den Anschluß 8 geschaltet wird. Hierbei wird die Gateelektrode 7 mit einem gegenüber dem Anschluß K negativen Löschspannungsimpuls beaufschlagt. In Figur 2 besteht der Schalter 9 aus einem Feldeffekttransistor, der über seinen Gateanschluß 11 durch einen Spannungsimpuls U₁ in den leitenden Zustand geschaltet wird.

Die n-Basis 3 erstreckt sich bis zur ersten Hauptfläche 12 des Thyristors und umschließt die p-Basisschicht 2, die sich auch bis zur Hauptfläche 12 erstreckt, lateral. Dabei trennt ein planarer pn-Übergang 13 die Basisschichten 2 und 3 voneinander. Der Randabschluß des pn-Übergangs 13 wird durch sogenannte Feldbegrenzungsringe 14 und 15 gebildet, die jeweils in einem konstanten Abstand zu der in der Hauptfläche 12 liegenden Begrenzung 16 der p-Basis 2 angeordnet sind und aus p⁺-dotierten, ringförmig in sich geschlossenen und von der Hauptfläche 12 ausgehenden Halbleiterzonen bestehen. Ihre Funktion besteht darin, in der Hauptfläche 12 einen hinreichend großen Abstand zwischen dem Rand 18 der unteren Begrenzung 17 und dem Rand 19 der oberen Begrenzung 20 der Raumladungszone 17, 20 zu gewährleisten, welche sich bei hohen Blockierspannungen zwischen den Anschlüssen A und K am pn-Übergang 13 aufbaut. Damit wird die Sperrfähigkeit des Thyristors in Vorwärtsrichtung von einem ohne die Feldbegrenzungsringe vorhandenen, niedrigen Wert, der der oberflächenseitigen Durchbruchspannung entspricht, auf einen wesentlichen höheren Wert, der der Volumensdurchspannung entspricht, angehoben. Derartige Feldbegrenzungsringe als Randabschluß eines planaren pn-Übergangs sind zum Beispiel aus dem Buch von A. Blicher "Thyristor Physics", erschienen im Springer-Verlag, 1976, S. 231-234, bekannt.

Die n-Basis enthält eine dünne, im wesentlichen parallel zur Hauptfläche 12 verlaufende Teilschicht 21, die wesentlich stärker n-dotiert ist als die übrigen Teile der n-Basis. Die Schichtdicke der Teilschicht 21 beträgt beispielsweise 20 µm. Sie erstreckt sich bis zum seitlichen Rand 22 des Halbleiterkörpers und wird dort von einer leitenden Belegung 23, zum Beispiel aus Aluminium, kontaktiert, die sich von dem seitlichen Rand 22 bis zur Hauptfläche 12 erstreckt und im Bereich der letzteren einen Anschluß 24 aufweist. Dieser ist über einen Schalter 25 mit dem negativen Pol einer Gleichspannungsquelle 26 verbunden, deren positiver Pol an den Anschluß A geführt ist. In Figur 2 ist der Schalter 25 durch einen Feldeffekttransistor dargestellt, dessen Gate mit einem Anschluß 27 versehen ist.

Im gezündeten bzw. stromführenden Zustand des Thyristors nach Figur 2 ist der pn-Übergang 13 mit beweglichen Ladungsträgern überschwemmt, so daß sich für den von A nach K fließenden Laststrom I ein niedriger Durchlaßwiderstand ergibt. Zum Abschalten des Thyristors wird der Gateanschluß 11 mit einem Spannungsimpuls U₁ beaufschlagt, so daß der Feldeffekttransistor 9 leitet und einen negativen Löschspannungsimpuls an die Gateelektrode 7 durchschaltet. Dabei baut sich die Raumladungszone 17, 20 an dem pn-Übergang 13 auf, was durch einen Abtransport der in der Nähe desselben vorhandenen beweglichen Ladungsträger in Richtung auf die Elektroden 5 und 6 geschieht. Neben den beim Aufbau der Raumladungszone abtransportierten Ladungsträgern sind aber insbesondere unterhalb der Begrenzung 17 noch weitere vorhanden, die zusätzlich abgesaugt werden müssen, um einen durch die Raumladungszone fließenden und die genannte Tailperiode verursachenden Diffusionsstrom zu vermeiden. Zu diesem Zweck wird das Gate 27 beim Abschalten des Thyristors mit einem Spannungsimpuls U₂ beaufschlagt, der den Feldeffektransistor 25 in den leitenden Zustand schaltet, so daß die Gleichspannungsquelle 26 mit dem Anschluß 24 verbunden wird. Damit wird die Teilschicht 21 auf ein Potential gelegt, das um den Betrag der von 26 gelieferten Gleichspannung niedriger ist als das Potential am Anschluß A. Beträgt die von 26 gelieferte Gleichspannung beispielsweise 10 Volt, so liegt die Teilschicht 21 um 10 Volt unter dem Potential der Elektrode 5. Positive Ladungsträger 28, die sich in dem unterhalb der Teilschicht 21 liegenden Teil der n-Basis 3 befinden, werden durch diese Potentialdifferenz in die Teilschicht 21 abgesaugt und gelangen zu den von der Belegung 23 kontaktierten Zonen derselben, wo sie mit negativen, von der Gleichspannungsquelle 26 gelieferten Ladungsträgern rekombinieren. Damit wird ein Driftstrom durch die Raumladungszone 17, 20 vermieden. Das bedeutet aber, daß in Figur 1 die Speicherzeit TS und die Fallperiode FP verkürzt werden und die Tailperiode TP praktisch entfällt. Der sich hierbei ergebende Stromverlauf beim Abschalten des Thyristors ist in Figur 1 durch die Kurve b gekennzeichnet.

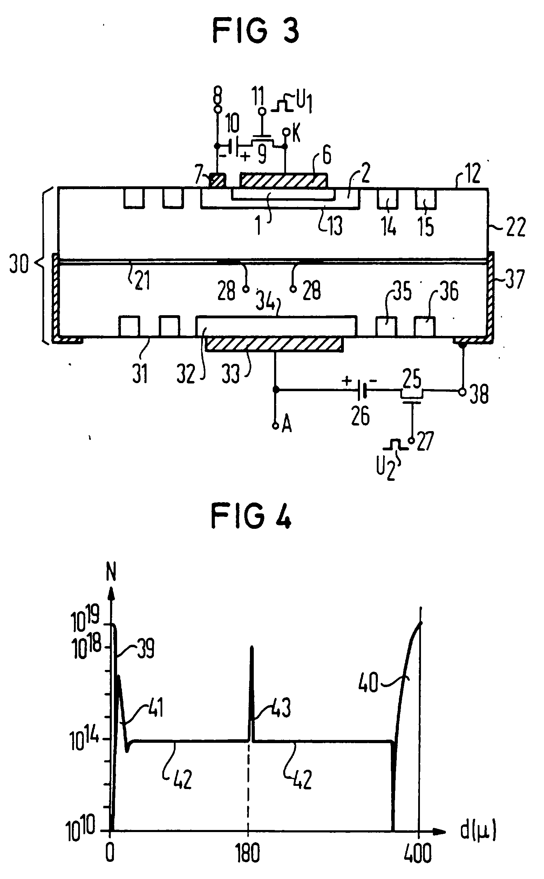

Figur 3 zeigt einen weiteren, nach der Erfindung ausgebildeten, abschaltbaren Thyristor, dessen der Figur 2 entsprechende Teile mit den gleichen Bezugszeichen wie dort versehen sind. Die n-Basis 3 von Figur 2 ist hier durch eine n-Basis 30 ersetzt, die sich sowohl bis zur oberen Hauptfläche 12 als auch bis zur unteren Hauptfläche 31 des Thyristors erstreckt. Sie umschließt den p-Emitter 32, der sich hier nur über einen Teil der senkrecht zur Stromrichtung des Laststroms I liegenden Querschnittsfläche des Thyristors erstreckt, lateral. Die anodenseitige Elektrode 33 ist gegenüber der Elektrode 5 entsprechend verkleinert. Der planare pn-Übergang 34 zwischen der n-Basis 30 und dem p-Emitter 32 wird lateral durch Feldbegrenzungsringe 35 und 36 abgeschlossen. Diese erhöhen die Sperrfähigkeit des Thyristors in Rückwärtsrichtung, das heißt bei anliegenden Sperrspannungen, die den Anschluß K auf ein höheres Potential legen als den Anschluß A. Dies erklärt sich daraus, daß sich beim Anlegen einer solchen Sperrspannung am Übergang 34 eine Raumladungszone aufbaut, deren in der Hauptfläche 31 liegende Ränder so weit voneinander entfernt sind, daß auch in diesem Fall nicht die oberflächenseitige Durchbruchspannung, sondern die größere Volumendurchbruchspannung die Sperrfähigkeit bestimmt. Die n⁺-dotierte Teilschicht 21 wird am seitlichen Rand 22 des Halbleiterkörpers von einer leitenden Belegung 37, zum Beispiel aus Aluminium, kontaktiert, die sich bis zur Hauptfläche 31 des Thyristors erstreckt und im Bereich der letzteren einen Anschluß 38 aufweist, der anstelle des Anschlusses 24 in Figur 2 mit dem Schalter 25 und über diesen unter Zwischenschaltung der Gleichspannungsquelle 26 mit dem Anschluß A verbunden ist. Das Absaugen der Ladungsträger 28 beim Anlegen einer gegenüber dem Anschluß A negativen Spannung an die Teilschicht 21 erfolgt in der bereits anhand von Figur 2 beschriebenen Weise.

Figur 4 zeigt das Dotierungsprofil der Thyristoren nach den Figuren 2 oder 3 in einem Diagramm, in dem die Dotierungskonzentrationen N der einzelnen Halbleitergebiete über dem Abstand d von der Hauptfläche 12 aufgetragen sind. Die etwa 10¹⁹cm⁻³ betragenden Dotierungskonzentrationen des n-Emitters 1 und des p-Emitters 4 bzw. 32 sind jeweils durch die Profilabschnitte 39 und 40 gekennzeichnet, die etwa 10¹⁷cm⁻³ betragende Dotierungskonzentration der p-Basis 2 durch den Profilabschnitt 41. In der mit etwa 10¹⁴cm⁻³ dotierten n-Basis 3 bzw. 30, die durch den Abschnitt 42 angedeutet ist, befindet sich in einem Abstand von 180 µm von der Hauptfläche 12 die mit etwa 10¹⁸cm⁻³ dotierte n⁺-Teilschicht 21, die durch den Profilabschnitt 43 gekennzeichnet ist. Die Dicke der Thyristoren beträgt etwa 400 µm.

Die hochdotierte Teilschicht 21 wird entweder durch Implantation von Donatorionen mit einer hohen Beschleunigungsspannung oder durch ein an sich bekanntes Epitaxieverfahren erzeugt. Im letzteren Fall geht man von einem n-dotierten Halbleiterkörper aus, der dem unterhalb der Teilschicht 21 liegenden Teil der n-Basis 3 bzw. 30 entspricht, und versieht diesen an seiner oberen Grenzfläche mittels eines Diffusions- oder Implantationsschrittes mit einer n⁺-dotierten Schicht, welche die spätere Teilschicht 21 darstellt. Anschließend wird der obere Teil der n-Basis 3 bzw. 32 mittels eines herkömmlichen Epitaxieverfahrens abgeschieden.

Eine andere Möglichkeit der Herstellung der Teilschicht 21 besteht darin, von zwei n-dotierten Halbleiterscheiben auszugehen, die jeweils etwa den oberhalb und unterhalb der Teilschicht 21 liegenden Thyristorteilen entsprechen. Nach Einfügung von dünnen n⁺-dotierten Schichten im Bereich der unteren, zuvor polierten Grenzfläche der oberen und im Bereich der oberen, zuvor polierten Grenzfläche der unteren Halbleiterscheibe werden beide Halbleiterscheiben mittels eines an sich bekannten Schweißverfahrens miteinander verbunden. Dabei bilden die dünnen n⁺-dotierten Schichten nach dem Verschweißen die Teilschicht 21, während die wesentlichen Teile beider Halbleiterscheiben die n-Basisschicht 3 bzw. 30 darstellen. Ein Schweißverfahren, das zur Verbindung von Siliziumscheiben dient, ist unter der Bezeichnung "Silicon wafer direct bonding (SDB)"-Verfahren bekannt geworden und zum Beispiel in den Extended Abstracts of the 18th (1986 International) Conference on Solid State Devices and Materials, Tokyo 1986, auf den Seiten 89 bis 92 beschrieben. Dabei werden die polierten Grenzflächen zweier Siliziumscheiben zunächst gereinigt, z.B. mit Wasser unter Zusatz von einem Lösungsmittel, sodann aufeinandergepreßt und schließlich auf eine Temperatur von 200°C oder mehr erhitzt.

Geht man von einem n-dotierten Halbleiterkörper aus, der nach einem der vorstehend beschriebenen Verfahren mit einer n⁺-dotierten Teilschicht 21 versehen ist, so führen die nachfolgenden weiteren Verfahrensschritte zur Herstellung eines erfindungsgemäßen Thyristors: zunächst werden in einem gemeinsamen Dotierungsschritt an der Oberseite und an der Unterseite dieses Halbleiterkörpers jeweils p-leitende Halbleiterschichten eingefügt, von denen die eine die p-Basisschicht 2 und die andere den an die n-Basisschicht 3 bzw. 30 angrenzenden p-Emitter 4 bzw. 32 des Thyristors darstellt. In einem weiteren Dotierungsschritt wird dann ein n-leitendes Gebiet in die p-Basisschicht 2 eingefügt, das den n-Emitter 1 darstellt. Die Halbleiterteile 1, 4 bzw. 32 und 2 werden jeweils mit der kathodenseitigen Elektrode 6, der anodenseitigen Elektrode 5 und der Gateelektrode 7 versehen.

Weiterhin wird die erste oder zweite leitende Belegung (23 oder 37) so aufgebracht, daß sie sich vom seitlichen Rand 22 des Halbleiterkörpers bis zur Oberseite bzw. Unterseite desselben erstreckt. Die erste leitende Belegung 23 wird schließlich auf der Oberseite des Halbleiterkörpers mit dem ersten Anschluß 24 versehen, die zweite leitende Belegung 37 mit dem zweiten Anschluß 38.

In Abweichung von den bisher beschriebenen Ausführungsformen der Erfindung kann die Teilschicht 21 auch so in die n-Basisschicht 3 bzw. 30 eingefügt werden, daß sie einen wesentlich geringeren Abstand zu den pn-Übergängen 29 bzw. 34 aufweist als zu dem pn-Übergang 13. Hierdurch erhöht sich die Sperrfähigkeit des Thyristors in Vorwärtsrichtung bei gleichzeitiger Verringerung seiner Sperrfähigkeit in Rückwärtsrichtung. Verschiebt man andererseits die Lage der Teilschicht 21 nach oben, so daß sie zum pn-Übergang 13 einen kleineren Abstand aufweist als zu den pn-Übergängen 29 bzw. 34, so wird die Sperrfähigkeit des Thyristors in Rückwärtsrichtung auf Kosten der Sperrfähigkeit in Vorwärtsrichtung vergrößert.

Weitere Ausführungsformen der Erfindung ergeben sich dadurch, daß sämtliche Halbleitergebiete bzw. -schichten durch solche des entgegengesetzten Leitungstyps ersetzt werden, wobei die zugeführten Spannungen durch solche des entgegengesetzten Vorzeichens zu ersetzen sind. Hierbei sind die Halbleitergebiete 3 bzw. 30 als p-Basisschichten anzusehen, wobei die über 21 abgesaugten Ladungsträger 28 aus Elektronen bestehen. Die Polaritäten der Spannungsquellen 10 und 26 müssen dabei umgedreht und die Bezeichnungen A und K miteinander vertauscht werden.

## Patentansprüche

1. Abschaltbarer Thyristor mit einem scheibenförmigen Halbleiterkörper, der einen von einer kathodenseitigen Elektrode (6) kontaktierten n-Emitter (1) mit einer angrenzenden p-Basisschicht (2) und einen von einer anodenseitigen Elektrode (5) kontaktierten p-Emitter (4) mit einer angrenzenden n-Basisschicht (3) aufweist, bei dem eine Gateelektrode (7) vorgesehen ist, die mit einem die Abschaltung des Thyristors bewirkenden Löschspannungsimpuls beaufschlagt wird, bei dem eine erste dieser beiden Basisschichten (3) sich bis zu einer ersten Hauptfläche (12) des Halbleiterkörpers erstreckt, die zweite, sich ebenfalls bis zur ersten Hauptfläche erstreckende Basisschicht (2) lateral umschließt und durch einen planaren pn-Übergang (13) von dieser getrennt ist, bei dem die erste Basisschicht (3) eine dünne, im wesentlich parallel zur ersten Hauptfläche (12) verlaufende und sich bis zum seitlichen Rand (22) des Halbleiterkörpers erstreckende Teilschicht (21) aufweist, die wesentlich stärker dotiert ist als der übrige Teil der ersten Basisschicht (3), bei dem eine die Teilschicht (21) kontaktierende erste leitende Belegung (23) vorgesehen ist, die im Bereich der ersten Hauptfläche (12) einen ersten Anschluß (24) aufweist, und bei dem der erste Anschluß (24) beim Abschalten des Thyristors mit einem Spannungsimpuls beschaltet wird, der zum Absaugen von im leitenden Zustand des Thyristors in der ersten Basisschicht (3) angesammelten Minoritätsladungsträgern dient, **dadurch gekennzeichnet**, daß die Teilschicht (21) am seitlichen Rand (22) des Halbleiterkörpers mit der ersten leitenden Belegung (23) kontaktiert ist.

2. Abschaltbarer Thyristor mit einem scheibenförmigen Halbleiterkörper, der einen von einer kathodenseitigen Elektrode (6) kontaktierten n-Emitter (1) mit einer angrenzenden p-Basisschicht (2) und einen von einer anodenseitigen Elektrode (33) kontaktierten p-Emitter (32) mit einer angrenzenden n-Basisschicht (30) aufweist, bei dem eine Gateelektrode (7) vorgesehen ist, die mit einem die Abschaltung des Thyristors bewirkenden Löschspannungsimpuls beaufschlagt wird, bei dem eine erste dieser beiden Basisschichten (30) sich bis zu einer zweiten Hauptfläche (31) des Halbleiterkörpers erstreckt, den angrenzenden, sich ebenfalls bis zur zweiten Hauptfläche (31) erstreckenden Emitter (32) lateral umschließt und durch einen planaren pn-Übergang (34) von diesem getrennt ist, bei dem die erste Basisschicht (30) eine dünne, im wesentlich parallel zur zweiten Hauptfläche (31) verlaufende und sich bis zum seitlichen Rand (22) des Halbleiterkörpers erstreckende Teilschicht (21) aufweist, die wesentlich stärker dotiert ist als der übrige Teil der ersten Basisschicht (30), bei dem eine die Teilschicht (21) kontaktierende und zweite leitende Belegung (37) vorgesehen ist, die im Bereich der zweiten Hauptfläche (31) einen zweiten Anschluß (38) aufweist, und bei dem der zweite Anschluß (38) beim Abschalten des Thyristors mit einem Spannungsimpuls beschaltet wird, der zum Absaugen von im leitenden Zustand des Thyristors in der ersten Basisschicht (30) angesammelten Minoritätsladungsträgern dient, **dadurch gekennzeichnet**, daß die Teilschicht (21) am seitlichen Rand (22) des Halbleiterkörpers mit der zweiten leitenden Belegung (37) kontaktiert ist.

3. Abschaltbarer Thyristor nach Anspruch 1 oder 2, **dadurch gekenzeichnet**, daß der erste (24) oder zweite Anschluß (38) über eine Gleichspannungsquelle (26) mit derjenigen Elektrode (5, 33) verbunden ist, die den sich bis zur zweiten Hauptfläche (31) des Halbleiterkörpers erstreckenden Emitter (4, 32) kontaktiert und daß die Gleichspannungsquelle (26) über einen ersten Schalter (25) lediglich während des Abschaltens des Thyristors wirksam schaltbar ist.

4. Verfahren zum Herstellen eines abschaltbaren Thyristors nach Anspruch 1 oder 2, **dadurch gekennzeichnet**, daß von einer oberen und einer unteren Halbleiterscheibe eines ersten Leitungstyps ausgegangen wird, wobei die untere Grenzfläche der oberen Halbleiterscheibe und die obere Grenzfläche der unteren Halbleiterscheibe poliert werden, daß in beide Halbleiterscheiben dünne oberflächenseitige Halbleiterschichten des zweiten Leitungstyps so eingefügt werden, daß sie jeweils von den polierten Grenzflächen ausgehen, daß die polierten Grenzflächen gereinigt werden, daß die Halbleiterscheiben sodann mit ihren polierten Grenzflächen aufeinandergelegt und dabei auf eine Temperatur von etwa 200°C oder mehr erhitzt werden, so daß die beiden Halbleiterscheiben miteinander verschweißt werden, wobei die eingefügten Halbleiterschichten des zweiten Leitungstyps gemeinsam die dünne Teilschicht (21) bilden und wesentliche Teile beider Halbleiterscheiben die erste Basisschicht (3, 30) darstellen, daß an der Oberseite (12) und Unterseite (31) des aus den beiden Halbleiterscheiben gebildeten Halbleiterkörpers durch einen Dotierungsschritt jeweils Halbleiterschichten (2, 4, 32) des zweiten Leitungstyps eingefügt werden, die die zweite Basisschicht (2) und den an die erste Basisschicht (3, 30) angrenzenden Emitter (4, 32) bilden, daß in einem weiteren Dotierungsschritt in die zweite Basisschicht (2) ein Halbleitergebiet des ersten Leitungstyps eingefügt wird, das den an diese Basisschicht (2) angrenzenden Emitter (1) bildet, daß die beiden Emitter (1, 4 bzw. 32) und die zweite Basisschicht (3, 30) jeweils mit der kathodenseitigen Elektrode (6), der anodenseitigen Elektrode (5 bzw. 33) und der Gateelektrode (7) versehen werden, daß die erste (23) oder zweite leitende Belegung (37) auf dem Halbleiterkörper so aufgebracht wird, daß sie sich vom seitlichen Rand (22) desselben bis zur Oberseite (12) oder Unterseite (31) des Halbleiterkörpers erstreckt, wobei sie am seitlichen Rand (22) desselben die Teilschicht (21) kontaktiert, und daß sie mit dem ersten (24) oder zweiten Anschluß (38) versehen wird.

## Claims

1. Gate turn-off thyristor having a semiconductor body which is in the form of a wafer and has an n-type emitter (1), which is made contact with by a cathode-side electrode (6) and has an adjoining p-type base layer (2), and a p-type emitter (4), which is made contact with by an anode-side electrode (5) and has an adjoining n-type base layer (3), in which a gate electrode (7) is provided, to which is applied a turn-off voltage pulse which effects the turning-off of the thyristor, in which a first of these two base layers (3) extends as far as a first main surface (12) of the semiconductor body, laterally encloses the second base layer (2), which likewise extends as far as the first main surface, and is separated from the said second base layer by a planar pn junction (13), in which the first base layer (3) has a thin partial layer (21) which runs essentially parallel to the first main surface (12), extends as far as the lateral edge (22) of the semiconductor body and is doped significantly more heavily than the remainder of the first base layer (3), in which a first conductive plating (23) is provided, which makes contact with the partial layer (21) and has a first connection (24) in the region of the first main surface (12), and in which, during the turning off of the thyristor, the first connection (24) is connected to a voltage pulse which serves to extract minority charge carriers which have accumulated in the first base layer (3) in the conducting state of the thyristor, characterized in that contact is made with the partial layer (21) at the lateral edge (22) of the semiconductor body by the first conductive plating (23).

2. Gate turn-off thyristor having a semiconductor body which is in the form of a wafer and has an n-type emitter (1), which is made contact with by a cathode-side electrode (6) and has an adjoining p-type base layer (2), and a p-type emitter (32), which is made contact with by an anode-side electrode (33) and has an adjoining n-type base layer (30), in which a gate electrode (7) is provided, to which is applied a turn-off voltage pulse which effects the turning-off of the thyristor, in which a first of these two base layers (30) extends as far as a second main surface (31) of the semiconductor body, laterally encloses the emitter (32), which likewise extends as far as the second main surface (31), and is separated from the said emitter by a planar pn junction (34), in which the first base layer (30) has a thin partial layer (21) which runs essentially parallel to the second main surface (31), extends as far as the lateral edge (22) of the semiconductor body and is doped significantly more heavily than the remainder of the first base layer (30), in which a first conductive plating (37) is provided, which makes contact with the partial layer (21) and has a second connection (38) in the region of the second main surface (31), and in which, during the turning off of the thyristor, the second connection (38) is connected to a voltage pulse which serves to extract minority charge carriers which have accumulated in the first base layer (30) in the conducting state of the thyristor, characterized in that contact is made with the partial layer (21) at the lateral edge (22) of the semiconductor body by the first conductive plating (23).

3. Gate turn-off thyristor according to Claim 1 or 2, characterized in that the first (24) or the second (38) connection is connected via a DC voltage source (26) to that electrode (5, 33) which makes contact with the emitter (4, 32) which extends as far as the second main surface (31) of the semiconductor body, and in that the DC voltage source (26) can be switched, via a first switch (25), to be active only during the turning-off of the thyristor.

4. Method for producing a gate turn-off thyristor according to Claim 1 or 2, characterized in that an upper and a lower semiconductor wafer of a first conduction type are used as the starting point, the lower boundary surface of the upper semiconductor wafer and the upper boundary surface of the lower semiconductor wafer being polished, in that thin surface-side semiconductor layers of the second conduction type are introduced into both semiconductor wafers in such a way that they each start at the polished boundary surfaces, in that the polished boundary surfaces are cleaned, in that the semiconductor wafers are then placed with their polished boundary surfaces one on top of the other and in the process are heated to a temperature of approximately 200°C or more, with the result that the two semiconductor wafers are welded to one another, the introduced semiconductor layers of the second conduction type jointly forming the thin partial layer (21) and substantial parts of both semiconductor wafers constituting the first base layer (3, 30), in that semiconductor layers (2, 4, 32) of the second conduction type, which form the second base layer (2) and the emitter (4, 32) adjoining the first base layer (3, 30), are introduced in each case by a doping Step at the top side (12) and bottom side (31) of the semiconductor body formed by the two semiconductor wafers, in that a semiconductor region of the first conduction type, which forms the emitter (1) adjoining the second base layer (2), is introduced into this base layer (2) in a further doping step, in that the two emitters (1, 4 and 32) and the second base layer (3, 30) are each provided with the cathode-side electrode (6), the anode-side electrode (5 and 33) and the gate electrode (7), in that the first (23) or second (37) conductive plating is applied to the semiconductor body in such a way that it extends from the lateral edge (22) of the latter as far as the top side (12) or bottom side (31) of the semiconductor body, the said plating making contact with the partial layer (21) at the lateral edge (22) of the said semiconductor body, and in that the said plate is provided with the first (24) or the second (38) connection.

## Revendications

1. Thyristor à passage à l'ouverture comportant un corps semi-conducteur en forme de disque, qui présente un émetteur-type N (1) mis en contact par une électrode (6) du côté de la cathode comportant une couche de base-type P (2) contiguë et un émetteur-type P (4) mis en contact par une électrode (5) du côté de l'anode comportant une couche de base-type N (3) contiguë, dans lequel une électrode de grille (7) est prévue, qui est alimentée avec une impulsion de tension d'effacement effectuant la déconnexion du thyristor, dans lequel une première couche de ces deux couches de base (3) s'étend jusqu'à une première surface principale (12) du corps semi-conducteur, entoure latéralement la deuxième couche de base (2), s'étendant également jusqu'à la première surface principale, et est séparée de celle-ci par une jonction-PN (13) planaire, dans lequel la première couche de base (3) présente une mince couche partielle (21), passant essentiellement en parallèle à la première surface principale (12) et s'étendant jusqu'au bord latéral (22) du corps semi-conducteur, qui est essentiellement plus fortement dopée que la partie restante de la première couche de base (3), dans lequel une première armature (23) conductrice mettant en contact la couche partielle (21) est prévue, qui présente dans la zone de la première surface principale (12) une première borne (24), et dans lequel la première borne (24) est commutée avec une impulsion de tension lors de la déconnexion du thyristor, qui sert à aspirer des porteurs de charge minoritaire accumulés dans la première couche de base (3) à l'état conducteur du thyristor, caractérisé en ce que la couche partielle (21) est mise en contact avec la première armature conductrice (23) au bord latéral (22) du corps semi-conducteur.

2. Thyristor à passage à l'ouverture comportant un corps semi-conducteur en forme de disque, qui présente un émetteur-type N (1) mis en contact par une électrode (6) du côté de la cathode comportant une couche de base-type P contiguë (2) et un émetteur-type P (32) mis en contact par une électrode (33) du côté de l'anode comportant une couche de base-type N (30) contiguë, dans lequel une électrode de grille (7) est prévue, qui est alimentée avec une impulsion de tension d'effacement effectuant la déconnexion du thyristor, dans lequel une première couche de ces deux couches de base (30) s'étend jusqu'à une deuxième surface principale (31) du corps semi-conducteur, entoure latéralement l'émetteur (32) contigu, s'étendant également jusqu'à la deuxième surface principale (31) et est séparée de celui-ci par une jonction-PN (34) planaire, dans lequel la première couche de base (30) présente une mince couche partielle (21), passant essentiellement en parallèle à la deuxième surface principale (31) et s'étendant jusqu'au bord latéral (22) du corps semi-conducteur, qui est dopée essentiellement plus fortement que la partie restante de la première couche de base (30), dans lequel est prévue une deuxième armature conductrice (37) mettant en contact la couche partielle (21), qui présente dans la zone de la deuxième surface principale (31) une deuxième borne (38), et dans lequel la deuxième borne (38) est commutée avec une impulsion de tension lors de la déconnexion du thyristor, qui sert à aspirer les porteurs de charge minoritaire accumulés dans la première couche de base (30) à l'état conducteur du thyristor, caractérisé en ce que la couche partielle (21) est mise en contact avec la deuxième armature conductrice (37) au bord latéral (22) du corps semi-conducteur.

3. Thyristor à passage à l'ouverture selon la revendication 1 ou 2, caractérisé en ce que la première (24) ou la deuxième borne (38) est raccordée par l'intermédiaire d'une source de tension continue (26) à l'électrode (5, 33), qui met en contact l'émetteur (4, 32) s'étendant jusqu'à la deuxième surface principale (31) du corps semi-conducteur et en ce que la source de tension continue (26) peut être connectée efficacement par l'intermédiaire d'un premier commutateur (25) uniquement pendant la déconnexion du thyristor.

4. Procédé pour la fabrication d'un thyristor à passage à l'ouverture selon la revendication 1 ou 2, caractérisé en ce que l'on part d'un disque semi-conducteur supérieur et d'un disque semi-conducteur inférieur d'une première nature de conductivité, l'interface inférieure du disque semi-conducteur supérieur et l'interface supérieure du disque semi-conducteur inférieur étant polies, en ce que de minces couches semi-conductrices superficielles de la deuxième nature de conductivité sont insérées dans les deux disques semi-conducteurs, de sorte qu'elles partent des interfaces polies, en ce que les interfaces polies sont nettoyées, en ce que les disques semi-conducteurs se placent ensuite l'un sur l'autre par leurs interfaces polies et sont en même temps chauffés à une température d'environ 200°C ou plus, de sorte que les deux disques semi-conducteurs sont soudés ensemble, les couches semi-conductrices insérées de la deuxième nature de conductivité formant ensemble la mince couche partielle (21) et des parties essentielles des deux disques semi-conducteurs constituant la première couche de base (3, 30), en ce que à chaque fois des couches semi-conductrices (2, 4, 32) de la deuxième nature de conductivité sont insérées par une étape de dopage sur le côté supérieur (12) et le côté inférieur (31) du corps semi-conducteur formé à partir des deux disques semi-conducteurs, ces couches forment la deuxième couche de base (2) et l'émetteur (4, 32) contigu à la première couche de base (3, 30), en ce que dans une autre étape de dopage, une région semi-conductrice de la première nature de conductivité est insérée dans la deuxième couche de base (2), qui forme l'émetteur (1) contigu à cette couche de base (2), en ce que les deux émetteurs (1, 4 resp. 32) et la deuxième couche de base (3, 30) sont pourvus à chaque fois de l'électrode du côté de la cathode (6), de l'électrode du côté de l'anode (5 resp. 33) et de l'électrode de grille (7), en ce que la première (23) ou la deuxième armature (37) conductrice est introduite sur le corps semi-conducteur de sorte qu'elle s'étend du bord latéral (22) de celui-ci jusqu'au côté supérieur (12) ou côté inférieur (31) du corps semi-conducteur, auquel cas elle met en contact la couche partielle (21) sur le bord latéral (22) de celui-ci, et en ce qu'elle est pourvue de la première (24) ou de la deuxième borne (38).
